(19) Europäisches Patentamt

European Patent Office

Office européen des brevets

(11) Veröffentlichungsnummer: **0 294 593 B1**

(12) **EUROPÄISCHE PATENTSCHRIFT**

(45) Veröffentlichungstag der Patentschrift: **07.10.92**

(21) Anmeldenummer: **88107234.2**

(22) Anmeldetag: **05.05.88**

(51) Int. Cl.⁵: **G01R 1/067**, G01R 31/28, G02F 1/03

(54) **Mechanische Sonde zur optischen Messung elektrischer Signale.**

(30) Priorität: **09.06.87 DE 3719203**

(43) Veröffentlichungstag der Anmeldung:
**14.12.88 Patentblatt 88/50**

(45) Bekanntmachung des Hinweises auf die
Patenterteilung:
**07.10.92 Patentblatt 92/41**

(84) Benannte Vertragsstaaten:
**DE FR GB NL**

(56) Entgegenhaltungen:
**WO-A-83/02829**
**US-A- 4 618 819**

**IEEE JOURNAL OF OUANTUM ELECTRONICS,
Band. OE-22, Nr. 1, Januar 1986, Seiten 79-93,
IEEE, New York, US; B.H. KOLNER et al.:
"Electrooptic sampling in GaAs integrated
circuits"**

(73) Patentinhaber: **SIEMENS AKTIENGESELL-
SCHAFT
Wittelsbacherplatz 2
W-8000 München 2(DE)**

(72) Erfinder: **Sölknerm, Gerald, Dipl.-Ing.
Naupliaallee 12
W-8012 Ottobrunn(DE)**

EP 0 294 593 B1

## Beschreibung

Die Erfindung betrifft eine mechanische Sonde zur optischen Messung elektrischer Signale nach dem Oberbegriff des Patentanspruchs 1.

Eine aus einem elektrooptischen Kristall bestehende Sonde ist aus der Veröffentlichung von J. A. Valdmanis "Subpicosecond electrical Sampling and applications" erschienen in Picosecond Optoelectronic Devices, Academic Press Inc. 1984, Seite 249 bis 270, insbesondere Seite 257 bis 258 und Figur 7, bekannt. Mit dieser Sonde können allerdings nur Messungen an speziellen Teststrukturen durchgeführt werden.

Eine für elektrooptische Sampling-Verfahren verwendbare Sonde ist aus den Electronics Letters, 14. Aug. 86, Vol. 22 No. 17, Seite 918-919 bekannt.

Der Erfindung liegt die Aufgabe zugrunde, eine mechanische Sonde der eingangs genannten Art anzugeben, mit der elektrische Signale an beliebigen Punkten einer Probe, insbesondere einer mikroelektronischen Schaltung, optisch mit hoher Zeitauflösung gemessen werden können.

Diese Aufgabe wird erfindungsgemäß durch eine mechanische Sonde nach Patentanspruch 1 gelöst.

Der mit der Erfindung erzielbare Vorteil besteht insbesondere darin, daß Signale in integrierten Schaltungen mit hoher Zeitauflösung optisch gemessen werden können.

Die Ansprüche 2 bis 6 sind auf bevorzugte Ausgestaltungen und Weiterbildungen der Erfindung gerichtet.

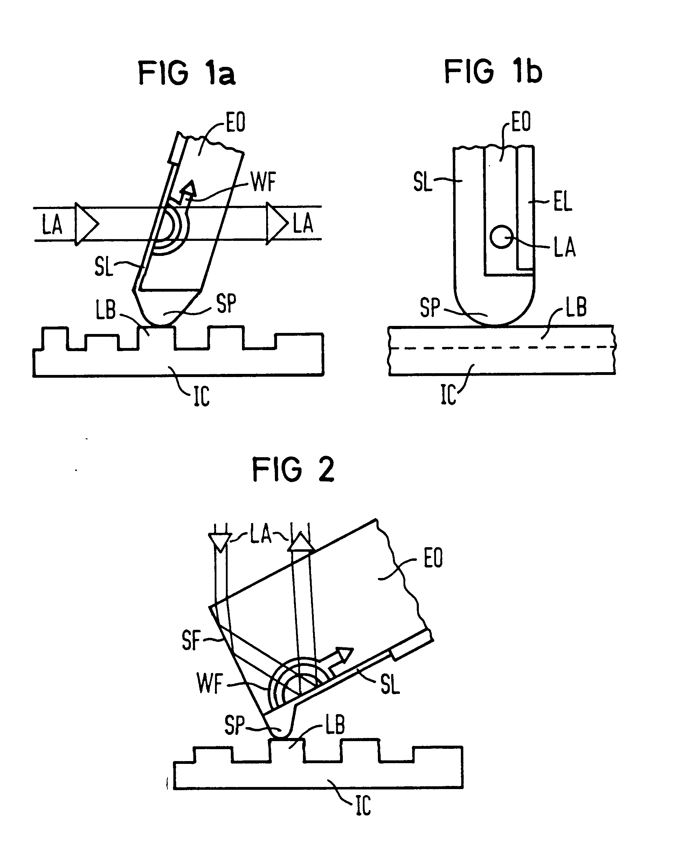

Die Erfindung wird nachfolgend anhand der Zeichnungen näher er-läutert. Hierbei zeigen die FIG 1 und 2 Ausführungsbeispiele erfindungsgemäßer Sonden zur optischen Messung elektrischer Signale.

Die in FIG 1 schematisch dargestellte mechanische Sonde besteht aus einem quaderförmigen elektrooptischen Kristall EO (Pockels-Kristall), beispielsweise Lithiumtantalat $LiTaO_3$ , Zinkselenit ZnSe oder Galliumarsenit GaAs, einer auf einer Seitenfläche des Kristalls EO angeordneten koplanaren Wellenleiterstruktur SL, EL und einer auf der probenseitigen Stirnfläche des Kristalls aufgebrachten metallischen Spitze SP, mit der das an einer Meßstelle, beispielsweise einer Leiterbahn LB einer integrierten Schaltung IC anliegende Signal abgegriffen und in die aus zwei streifenförmigen Metallisierungen SL, EL bestehende koplanare Wellenleiterstruktur eingespeist wird. Die Zeitabhängigkeit des in der Wellenleiterstruktur mit der Geschwindigkeit $v_s < c$ ($c$ = Lichtgeschwindigkeit) laufenden Signals kann man in bekannter Weise (siehe beispielsweise die eingangs zitierten Veröffentlichungen) unter Ausnutzung des linearen elektrooptischen Effektes (Pockels-Effekt) mit Hilfe eines das elektrische Wanderfeld WF im Kristall EO detektierenden polarisierten Laserstrahls LA aufzeichnen. Angewandt wird üblicherweise ein Sampling-Verfahren, bei dem man den in einem Raster-Lasermikroskop erzeugten und parallel zur Bausteinoberfläche laufenden Laserstrahl LA synchron mit dem an der Leiterbahn LB anliegenden Signal eintastet und die Phasenlage der Laserpulse bezüglich des Signals, beispielsweise durch Verlängerung bzw. Verkürzung des Strahlengangs zwischen Laserquelle und Kristall EO, kontinuierlich verändert. Um die Dispersion zu minimieren, sollte der Laserstrahl LA den elektrooptischen Kristall EO in unmittelbarer Nähe der metallischen Spitze SP zwischen den als Signal- bzw. Erdleitung wirkenden streifenförmigen Metallisierungen SL und EL der Wellenleiterstruktur durchsetzen (siehe FIG 1 b). Zur Positionierung des etwa 0.5 - 1 mm langen elektrooptischen Kristalls EO auf der Leiterbahn LB können konventionelle, aus der elektrischen Meßtechnik (Spitzenmeßplatz) bekannte Sondenhalter verwendet werden, die man mittels Magnet-oder Vakuumadaptern auf einer beispielsweise durch vier synchron laufende Leitspindeln exakt linear höhenverstellbaren Bühne fixiert. Ein solcher Sondenhalter besteht üblicherweise aus einer Halterung zur Aufnahme der Sonde, einem Sondenarm und einer Feinmechanik, die eine lineare Verschiebung der Sonde in drei zueinander orthogonale Richtungen gestattet. Anstelle dieser Sondenhalter können selbstverständlich auch elektrostriktive Manipulatoren mit einer für moderne hochintegrierte Schaltungen ausreichenden Positioniergenauigkeit von etwa 0,1 $\mu$m verwendet werden.

Zur Angleichung der Ausbreitungsgeschwindigkeit $c$ der Laserstrahlung LA im elektrooptischen Kristall EO an die Ausbreitungsgeschwindigkeit $v_s <$ $c$ des mit der Lasersonde LA abzutastenden elektrischen Wanderfeldes WF muß die Längsachse der mechanischen Sonde einen von 90° abweichenden Winkel $\alpha$ mit der Ausbreitungsrichtung der Laserstrahlung LA einschließen. Dieser vom jeweils verwendeten elektrooptischen Material abhängige Winkel $\alpha$ beträgt für $LiTaO_3$ annähernd 72° .

Die in FIG 2 schematisch dargestellte mechanische Sonde erlaubt die Verwendung eines senkrecht zur Bausteinoberfläche einfallenden Laserstrahls LA zur Abtastung des in dem quaderförmigen elektrooptischen Kristall EO erzeugten elektrischen Wanderfeldes WF. Auch bei diesem Ausführungsbeispiel wird das an der Leiterbahn LB anliegende Signal über eine metallische Spitze SP in die auf der Kristallunterseite angeordnete und als Spiegel für den an der Stirnseite SF des Kristalls EO totalreflektierten Laserstrahl LA dienende Wellenleiterstruktur eingespeist. Den Winkel der Totalreflexion kann man hierbei mit Hilfe der Manipulatoren bzw. Sondenhalter so einstellen, daß die in Richtung der Längsachse der Sonde gemessene Komponente der Ausbreitungsgeschwindigkeit der Laserstrahlung mit der Ausbreitungsgeschwindigkeit $v_s$ des elektrischen Wanderfeldes WF nahezu übereinstimmt (für LiTaO$_3$ beträgt der Winkel der Totalreflexion etwa 90 - 72 = 18°). Das in FIG 2 dargestellte Ausführungsbeispiel besitzt gegenüber der mechanischen Sonde nach FIG 1 den Vorteil, daß das zur Abbildung der Probenoberfläche bzw. zur Positionierung der Sonde auf der Meßstelle verwendete optische System (Raster-Lasermikroskop) mit der Meßeinrichtung zur Aufzeichnung des Signals identisch ist.

Die Erfindung ist selbstverständlich nicht auf die beschriebenen Ausführungsbeispiele beschränkt. So kann die probenseitige Fläche des in FIG 2 dargestellten elektrooptischen Kristalls noch mit einer reflektierenden Schicht versehen sein.

Anstelle der aus zwei streifenförmigen Metallisierungen SL, EL bestehenden Wellenleiterstruktur sind auch andere Wanderwellenanordnungen verwendbar.

Die metallische Spitze SP zur Kontaktierung der Meßstelle LB kann beispielsweise durch Bedampfen der probenseitigen Stirnfläche des elektrooptischen Kristalls EO erzeugt werden.

## Patentansprüche

1. Mechanische Sonde zur optischen Messung elektrischer Signale mit einem von elektromagnetischer Strahlung (LA) durchsetzten elektrooptischen Kristall (EO), **gekennzeichnet** durch eine auf dem elektrooptischen Kristall (EO) angeordnete Meßspitze (SP) und eine mit der Meßspitze (SP) leitend verbundene, auf dem elektrooptischen Kristall (EO) angeordnete Wellenleiterstruktur (SL, EL).

2. Mechanische Sonde nach Anspruch 1, dadurch **gekennzeichnet,** daß die Wellenleiterstruktur (SL, EL) auf der einer Strahlungsquelle zugewandten Fläche des elektrooptischen Kristalls (EO) angeordnet ist.

3. Mechanische Sonde nach Anspruch 1, dadurch **gekennzeichnet,** daß die Wellenleiterstruktur (SL, EL) auf der einer Strahlungsquelle gegenüberliegenden Fläche des elektrooptischen Kristalls (EO) angeordnet ist.

4. Mechanische Sonde nach einem der Ansprüche 1 bis 3, dadurch **gekennzeichnet,** daß die die Wellenleiterstruktur (SL, EL) tragende Fläche des elektrooptischen Kristalls (EO) so relativ zur einfallenden Strahlung (LA) ausgerichtet ist, daß eine Komponente der Lichtgeschwindigkeit (c) der elektromagnetischen Strahlung im elektrooptischen Kristall (EO) annähernd gleich der Signalgeschwindigkeit ($V_S$) in der Wellenleiterstruktur (SL, EL) ist.

5. Mechanische Sonde nach Anspruch 3, dadurch **gekennzeichnet,** daß die die Wellenleiterstruktur (SL, EL) tragende Fläche des elektrooptischen Kristalls (EO) mit einer reflektierenden Schicht versehen ist.

6. Mechanische Sonde nach einem der Ansprüche 1 bis 5, **gekennzeichnet** durch eine aus zwei streifenförmigen Metallisierungen (SL, EL) bestehende koplanare Wellenleiterstruktur.

## Claims

1. Mechanical probe for the optical measurement of electrical signals having an electro-optical crystal (EO) penetrated by electromagnetic radiation (LA), characterised by a measuring tip (SP) which is disposed on the electro-optical crystal (EO) and a waveguide structure (SL, EL) which is conductively connected to the measuring tip (SP) and is disposed on the electro-optical crystal (EO).

2. Mechanical probe according to Claim 1, characterised in that the waveguide structure (SL, EL) is disposed on the surface of the electro-optical crystal (EO) which faces a radiation source.

3. Mechanical probe according to Claim 1, characterised in that the waveguide structure (SL, EL) is disposed on the surface of the electro-optical crystal (EO) which is situated opposite a radiation source.

4. Mechanical probe according to one of Claims 1 to 3, characterised in that that surface of the electro-optical crystal (EO) which carries the waveguide structure (SL, EL) is aligned relative to the incident radiation (LA) so that a component of the speed of light (c) of the electromagnetic radiation in the electrooptical crystal (EO) is approximately equal to the signal velocity ($V_S$) in the waveguide structure (SL, EL).

5. Mechanical probe according to Claim 3, characterised in that that surface of the electro-optical crystal (EO) which carries the waveguide structure (SL, EL) is provided with a reflective layer.

6. Mechanical probe according to one of Claims 1 to 5, characterised by a coplanar waveguide structure consisting of two strip-shaped metallisations (SL, EL).

## Revendications

**1.** Sonde mécanique pour la mesure optique de
signaux électriques, comportant un cristal
électro-optique (EO) traversé par un rayonnement électromagnétique (LA), caractérisée par
une pointe de mesure (SP) disposée sur le
cristal électro-optique (EO), et une structure
formant guide d'ondes (SL, EL), raccordée de
façon conductrice à la pointe de mesure (SP)
et disposée sur le cristal électro-optique (EO).

**2.** Sonde mécanique suivant la revendication 1,
caractérisée par le fait que la structure formant
guide d'ondes (SL, EL) est disposée sur la
surface du cristal électro-optique (EO), tournée
vers une source de rayonnement.

**3.** Sonde mécanique suivant la revendication 1,
caractérisée par le fait que la structure formant
guide d'ondes (SL,EL) est disposée sur la surface du cristal électro-optique (EO), située en
vis-à-vis d'une source de rayonnement.

**4.** Sonde mécanique suivant l'une des revendications 1 à 3, caractérisée par le fait que la
surface, qui porte la structure formant guide
d'ondes (SL,EL), du cristal électro-optique (EO)
est orientée par rapport au rayonnement incident (LA) de telle sorte qu'une composante de
la vitesse de la lumière (c) du rayonnement
électromagnétique dans le cristal électro-optique (EO) est approximativement égale à la
vitesse ($V_S$) du signal dans la structure formant
guide d'ondes (SL,EL).

**5.** Sonde mécanique suivant la revendication 3,
caractérisée par le fait que la surface, qui porte
la structure formant guide d'ondes (SL,EL), du
cristal électro-optique (EO) comporte une couche réfléchissante.

**6.** Sonde mécanique suivant l'une des revendications 1 à 5, caractérisée par une structure
coplanaire formant guide d'ondes, constituée
par deux métallisations en forme de bandes
(SL,EL).

## FIG 1a

## FIG 1b

## FIG 2